# EUROPÄISCHE PATENTSCHRIFT

(11) **EP 2 273 575 B1**
(45) Veröffentlichungstag und Bekanntmachung des Hinweises auf die Patenterteilung: **07.08.2019**
(21) Anmeldenummer: 10185808.2
(22) Anmeldetag: 09.06.2004
(51) Int. Cl.: H01L 25/075, H01L 33/50

(54) **Weisse LED-Lichtquelle**
White LED light source
Source lumineuse à DEL blanche

(30) Priorität: 18.06.2003 AT 9482003
(43) Veröffentlichungstag der Anmeldung: 12.01.2011
(62) Teilanmeldung aus: 04741759.7
(73) Patentinhaber: Tridonic Jennersdorf GmbH, 8380 Jennersdorf (AT)
(72) Erfinder: Leising, Günther, 8042, Graz (AT)
(74) Vertreter: Rupp, Christian

(56) Entgegenhaltungen:
- EP-A2- 1 248 304
- EP-A2- 1 296 376
- WO-A1-97/50132
- WO-A2-03/038902
- DE-A1- 10 135 306
- US-B1- 6 351 069

## Beschreibung

### Technisches Umfeld

Die Erfindung betrifft einen Satz an Lichtemittierenden Dioden (LEDs), die weißes Licht mit vorgegebener Farbtemperatur aussenden. Im Folgenden werden als "weiße LED" bezeichnet, bei denen eine blaues Licht aussendende LED, im Folgenden als "blaue LED" bezeichnet, mit einer Konversionsschicht, die blaues Licht absorbiert und Licht größerer Wellenlänge emittiert, beschichtet werden. Bei einer blauen LED wird ein Teil der blauen Emission in einen anderen Wellenlängenbereich konvertiert, so dass die Summe der emittierten Lichtkomponenten weißes Licht ergibt. Die Erfindung betrifft weiters ein LED-Modul, der einen solchen Satz an weißen LEDs aufweist.

Die Farbkonversionsschicht besteht typisch aus anorganischen oder organischen Farbkonversionspigmenten, welche in einer organischen Kunststoffschicht verteilt sind.

Im Hinblick auf eine reproduzierbare Herstellung von weißen LEDs innerhalb enger Toleranzen des resultierenden Farbortes muss beim Herstellungsprozess neben der Konzentration der Pigmente auch die Schichtdicke (und deren Form) exakt definiert sein.

Im Stand der Technik sind diesbezüglich verschiedene Prozesse bekannt:
1) Das Farbkonversionsmedium füllt den Reflektor-Cup, in welchen die LED eingesetzt wird, aus
   (JP 8335719 A --.
   JP 8335720 A --.);
2) Das Farbkonversionsmedium wird in Tropfenform über dem LED-Chip aufgebracht (mit transparentem Spacer:
   US 5959316 A -.
   JP 10190065 A --.);
3) Das Farbkonversionsmedium wird in die Klebeschicht zwischen der LED und einer Linse eingebracht (US 6590235 B --.);
4) Das Farbkonversionsmedium wird in Schichtform definiert hergestellt und auf der LED befestigt (EP 1081771 A--.);
5) Die Farbkonversionsschicht wird direkt auf den LED-Chip gedruckt (JP 2001244507 A--.).

WO 03/038902 A offenbart ein Verfahren zur Herstellung einer weißen LED mit vorgegebener Farbtemperatur, die mehrere blaue LED-Chips aufweist, bei dem die genaue Wellenlänge der LED-Chips bestimmt wird, die LED-Chips mit einer Konversionsschicht, die blaues Licht absorbiert und Licht größerer Wellenlänge emittiert, beschichtet werden, wobei das Farbkonversionsmittel in einer von der ermittelten Wellenlänge abhängigen Menge aufgebracht wird.

DE 10135306 A1 offenbart eine weiße LED-Lichtquelle mit mehreren blauen LED-Chips die eine Wellenlänge von 455 nm aufweisen, die jeweils mit einer Konversionsschicht aus einem Farbkonversionsmittel beschichtet sind, die blaues Licht absorbiert und Licht größerer Wellenlänge emittiert, wobei je nach vorliegendem Spektrum eine andere Menge Farbkonversionsmittel auf den jeweiligen LED-Chip aufgebracht wird, so dass die Farbtemperatur des modulierten Lichts der LED-Lichtquelle bei 6000K liegt.

Diese Methoden erfüllen die Anforderungen für viele Anwendungen, speziell für Beleuchtung, unzureichend. Die Herstellungsmethode und deren Toleranzen sind wesentliche Gründe für die Abweichungen. Ein weiterer Grund ist der folgende:

Die Anregbarkeit der Farbkonversionsmittel hängt typischerweise stark von der Wellenlänge der anregenden LEDs ab. Speziell bei langwelligen blauen LEDs führt eine WeDenlängentoleranz von nur einigen Nanometern bereits zu signifikant unterschiedlichen Emissionsintensitäten bei den derzeitigen Farbkonversionsmitteln. Im Falle von UV-LEDs würde dies vorwiegend zu einer Intensitätsschwankung führen, im Falle von blauen LEDs darüber hinaus zu einer Farbverschiebung, da sich in diesem Fall das weiße Licht aus der blauen LED-Emission und der Emission des Farbkonversionsmittels zusammensetzt.

Da LEDs gemäß dem Stand der Produktionstechnik eine relativ breite Wellenlängenverteilung aufweisen, weist eine typische Selektionsklasse eine Wellenlängentoleranz von mehr als 5 nm auf. Selbst bei sehr definierter Aufbringung der Farbkonversionsmittel (mit vernachlässigbarer Toleranz) resultiert hieraus eine Toleranz der Farbtemperatur weißer LEDs von mehr als ± 300 K. Dies ist für viele Anwendungen bereits zu hoch. Es entspricht daher dem Stand der Technik, dass die Marktforderung nach enger spezifizierten weißen LEDs durch Selektionsverfahren realisiert wird.

### Offenbarung der Erfindung

### Technisches Problem

Es ist Aufgabe der Erfindung, weiße LEDs zu schaffen, welche geringere Toleranz der Farbtemperatur haben, als es dem Stand der Technik entspricht. Weiters soll ein weißes LED-Modul geschaffen werden, die eine geringere Schwankungsbreite der Farbtemperatur hat, die insbesondere also über der gesamten Emissionsfläche eine nahezu konstante Farbtemperatur hat.

### Technische Lösung

Diese Aufgabe wird erfindungsgemäß dadurch gelöst, dass die genaue Wellenlänge der LED vor dem Aufbringen des Farbkonversionsmittels bestimmt wird und sodann das Farbkonversionsmittel über dieser LED in einer von der ermittelten Wellenlänge abhängigen Konzentration aufgebracht wird.

Im Gegensatz zum Stand der Technik ist durch die Erfindung eine Herstellung von weißen LEDs mit definierter Farbtemperatur und definierter Toleranz möglich, ohne dass ein weiteres Selektionsverfahren notwenig wäre.

Der Herstellungsprozess kann grob folgendermaßen beschrieben werden:

LEDs werden in Wafern hergestellt. Es entspricht dem Stand der Technik, dass die einzelnen LEDs auf einem Wafer einzeln bezüglich Helligkeit und Wellenlänge (Δλ < 1nm) vermessen werden (Wafer Mapping, siehe Produktspezifikation der Maschinenhersteller, z.B. ASM). Diese Daten werden in weiterer Folge dazu verwendet, die LEDs nach dem Vereinzeln in verschiedene Klassen zu selektieren. Alternativ können die optischen Daten der LEDs einzeln vor der Aufbringung der Farbkonversion mittels Spektrometer (oder Chromameter) gemessen werden.

In gegenständlicher Erfindung wird die Information des Wafer Mappings dazu benutzt, um auf jede LED selektiv eine spezielle Menge Farbkonversionsmittel aufzubringen. Die Menge an Farbkonversionsmittel ist hierbei selektiv durch entsprechende Wahl der Konzentration (bei verdünnten Systemen) auf die jeweilige LED abgestimmt.

Bei der Aufbringung des Farbkonversionsmittels gibt es folgende Möglichkeiten:
Selektives Dispensen oder Stempeln
Selektives Inkjet Printing
Selektives Verdampfen durch Masken
Selektives nachträgliches Einstellen der Dicke und Form der Schicht des Farbkonversionsmittels (z.B. durch Laser wie beim Widerstandstrimmen).

Zur Vereinfachung werden die LEDs in Gruppen zusammengezogen, z.B. jeweils im Bereich von 1 nm.

### Kurze Beschreibung von Zeichnungen

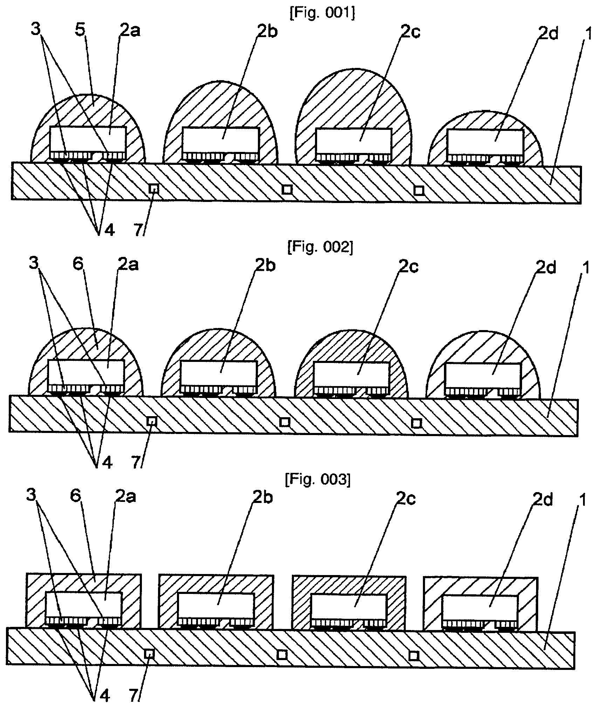

Anhand der Zeichnung wird die Erfindung näher erläutert. Es zeigt: Fig. 1 ein nicht erfindungsgemäßes Beispiel von LED's mit unterschiedlicher Menge von Binder, in dem sich das Farbkonversionsphosphorpigment befindet; Fig. 2 ein erfindungsgemäßes Ausfuhrungsbeispiel von LED's mit gleichen Mengen von Binder, in dem sich das Farbkonversionsphosphorpigment mit unterschiedlicher Konzentration befindet; und Fig. 3 zeigt eine Abwandlung der Ausführungsform gemäß Fig. 2.

Es folgen nun fünf Beispiele:

### I.) Nicht erfindungsgemäßes Beispiel: Farbkonversionsphosphorpigment dispergiert in organischem Binder mit konstanter Konzentration - Aufbringen mittels Dispenser

In Fig. 1 ist eine Platine 1 gezeigt, auf der sich vier LED-Dices 2a, 2b, 2c, 2d befinden. Diese LED-Dices 2a, 2b, 2c, 2d sind in Flip-Chip-Technologie aufgebracht, d.h. die Anschlüsse 3 befinden sich auf der Unterseite und sind mit Kontakt-Bumps 4 mit der Platine 1 verbunden. Über jedem LED-Dice 2a, 2b, 2c, 2d befindet sich ein Tropfen eines Binders 5, der das Farbkonversionsphosphorpigment enthält.

Man stimmt die Tropfenmenge auf die Wellenlänge der LED-Dices 2a, 2b, 2c, 2d ab. Gemäß der ermittelten Wellenlänge der einzelnen LED-Dices 2a, 2b, 2c, 2d wird die Tropfenmenge erhöht für langwellige LED-Dices 2b, 2c, während diese für kurzwellige LED-Dices 2d reduziert wird. Da die Viskosität und Thixotropie der Paste von der Konzentration des Farbkonversionspigmentes abhängt, kann auch eine Veränderung der Tropfenform erzielt werden (bei einer volumetrischen Dosierung).

Mit diesen Methoden konnte durch eine Variation des Dispens-Volumens zwischen 0,02 und 0,03 cm³ auf Dices, deren Wellenlängen zwischen 460 und 475 nm variierten, weißes Licht mit einer Farbtemperatur von 6500 ± 300 K realisiert werden.

### II.) Erfindungsgemäßes Ausführungsbeispiel: Farbkonversionphosphorpigment dispergiert in organischem Binder mit variabler Konzentration - Aufbringen mittels Dispenser.

Gemäß der Wellenlänge der einzelnen LED-Dices 2a, 2b, 2c, 2d (siehe Fig. 2) wird die Konzentration der Phosphorpigmente im Binder 6 in der Matrix adaptiert. Dies wird bevorzugt durch das Verwenden von mehreren Dispens- oder Stempelbehältern mit unterschiedlichen Konzentrationen der Phosphorpigmente erreicht Die unterschiedliche Konzentration ist in Fig. 2 durch Schraffen mit unterschiedlichem Abstand angedeutet

Optional kann nach dem Dispens- oder Stempelvorgang ein Druckvorgang angeschlossen werden, um eine ebene und definierte Form des Farbkonversionsmediums zu erreichen (siehe Fig. 3). Hiezu wird über der LED-Anordnung eine Maske aufgelegt, in deren Ausnehmungen das Farbkonversionsmedium mittels Dispenser aufgebracht wird. Abschließend wird mittels eines Rakels das über die Maske herausstehende Material entfernt.

Mit diesen Methoden werden durch eine Variation des Phosphorpigmentes in der organischen Matrix zwischen 10 und 30 Masse-% auf Dices mit einer Wellenlängenvariation zwischen 460 und 475 nm weißes Licht mit einer Farbtemperatur von 6500±200K realisiert.

Die Methoden I und II werden bevorzugt für LED-Dices eingesetzt, die Face Down (Elektrode nach unten) auf Trägermaterialien (Halbleiterträger oder printed circuit board = PCB) angeordnet sind, da es bei einer Face Up Montage schwierig ist, die Elektroden frei von der Farbkonversionspaste zu halten. Die derart montierten LEDs werden in einem Mapping-Verfahren einzeln bezüglich der Wellenlänge vermessen und mit diesen Daten wird der Dispenser programmiert. Die einzelnen LEDs können nachfolgend entlang von Trennlinien 7 geteilt und zu LED-Lichtquellen verarbeitet werden bzw. auch als LED-Modul eingesetzt werden.

### III.) Farbkonversionsphosphorpigment dispergiert in organischem Binder - Aufbringen mittels Inkjet Printing.

Das Inkjet Printing stellt eine Verfeinerung der Dispensmethoden I-II dar. Hiezu sind feinkörnige Pigmente (im Bereich von höchstens einigen Mikrometern Durchmesser) notwendig.

Die individuelle Einstellung der Farbkonversion pro LED kann derart mittels der Anzahl der gesetzten Inkjettropfen (=volumetrisch) oder der Konzentration durch Einsatz verschiedener Inkjet-Tinten (aus verschiedenen Kartuschen) oder deren Kombination erfolgen.

### IV.) Nicht erfindungsgemäßes Beispiel: Aufbringen der Farbkonversionsmaterialien aus der Gasphase

Gemäß dem Stand der Technik sind einige Materialien (ZnS:Mn) bekannt, die sich zur Farbkonversion des von LEDs ausgesandten Lichts eignen und welche mittels Gasphasenmethoden abgeschieden werden können.

Einer der Vorteile dieser Methoden ist, dass die Elektroden der LEDs selektiv abgedeckt werden können und daher diese Methode auch für Face Up montierte LEDs sehr gut geeignet ist. (Man kann die Kontaktflächen einfach abdecken.)

Die selektive Farbkonversion wird bei dieser Methode durch definierte Einstellung der aufgebrachten Menge des Farbkonversionsmaterials erreicht. Dies kann im einfachsten Fall durch Anbringen einer Maske (typisch Photomaske), die speziell auf den zu beschichteten LED Wafer (gemäß den Wafer Mapping Daten) abgestimmt ist, erfolgen. Derart wird eine LED mit der höchsten Wellenlänge (was normalerweise beste Anregbarkeit bewirkt) vollständig beschichtet, während bei LEDs mit geringerer Wellenlänge nur Teile der Oberfläche beschichtet werden.

### V.) Nicht erfindungsgemäßes Beispiel: Trimmen der Dicke und Form der Farbkonversionsschicht

Das Einstellen der Farbkonversion bei vollflächig aufgebrachten Schichten (gleicher Konzentration) kann auch nachträglich erfolgen. Hiezu kann ein Verfahren angewandt werden, welches in der Halbleiter- und Drucktechnik eingesetzt wird, um z.B. Widerstände definiert abzugleichen. Hiezu wird die beschichtete LED derart getrimmt, dass ein Laser Farbkonversionsmaterial vom der Oberfläche der LEDs definiert abträgt (Laserablation), sodass die gewünschte Farbe durch die definierte Menge an übrig gelassenem Farbkonversionsmaterial unabhängig von der Wellenlänge der LED erreicht wird.

## Patentansprüche

1. Satz an weißen LEDs, jeweils mit einer blauen LED (2a, 2b, 2c, 2d), die mit einer Konversionsschicht aus einem Farbkonversionsmittel beschichtet ist, die blaues Licht absorbiert und Licht größerer Wellenlänge emittiert, wobei die blauen LEDs eine Wellenlänge zwischen 460 und 475nm aufweisen; wobei die Konzentration der Konversionsschicht über jeder blauen LED von der genauen Wellenlänge der jeweiligen blauen LED abhängt, wobei die Konzentration von Phosphorpigmenten in einer organischen Matrix (6) der Konversionsschicht zwischen 10 und 30 Masseprozent variiert, und
wobei die Gesamt-Emissionsflächen der weißen LEDs eine Farbtemperatur von 6500 ±200K aufweisen.

2. Satz an weißen LEDs nach Anspruch 1,
**dadurch gekennzeichnet, daß** die Konversionsschicht aus anorganischen oder organischen Farbkonversionspigmenten besteht, welche in einer organischen Kunststoffschicht (6) verteilt sind.

3. LED-Modul, das einen Satz an weißen LEDs nach einem der vorhergehenden Ansprüchen aufweist, wobei die LED-Dices (2a, 2b, 2c, 2d) der blauen LEDs Face Down auf einem Trägermaterial (1) angeordnet sind.

4. LED-Modul nach Anspruch 3,
**dadurch gekennzeichnet,**
**daß** das Trägermaterial (1) ein Halbleiterträger oder ein PCB ist.

## Claims

1. Set of white LEDs, each having a blue LED (2a, 2b, 2c, 2d) coated with a conversion layer consisting of
a color converting means, which absorbs blue light and emits light having a coarser wavelength,
wherein the blue LEDs have a wavelength between 460 and 475 nm;
wherein the concentration of the conversion layer over each blue LED is a function of the precise
wavelength of the respective blue LED, wherein the concentration of phosphor pigments in an organic matrix (6) of the conversion layer varies between 10 and 30
mass percent, and
wherein the total emission surfaces of the white LEDs have a color temperature of 6500 ± 200K.

2. Set of white LEDs according to Claim 1,
**characterized in that** the conversion layer consists of inorganic or organic color converting pigments which are distributed in an organic plastic layer (6).

3. LED module comprising a set of white LEDs according to any one of the preceding Claims, wherein the LED dices (2a, 2b, 2c, 2d) of the blue LEDs are disposed face down on a carrier material (1).

4. LED module according to Claim 3,
**characterized in that**
the carrier material (1) is a semiconductor carrier or a PCB.

## Revendications

1. Ensemble dediodes électroluminescentes blanches, respectivement avec une LED (2a, 2b, 2c, 2d) bleue, qui est revêtue d'une couche de conversion à base
d'un milieu de conversion de couleur qui absorbe de la lumière bleue et émet de la lumière de longueur d'onde plus élevée,
où les LED bleues présentent une longueur d'onde entre 460 et 475 nm ;
où la concentration de la couche de conversion au niveau de chaque LED bleue dépend
de la longueur d'onde précise de la LED bleue respective, où la concentration de pigments de phosphore dans une matrice organique (6) de la couche de conversion varie entre 10 et 30 pour cent en masse, et
où les surfaces d'émission totales des LED blanches présentent une température de couleur de 6500 ± 200 K.

2. Ensemble de LED blanches selon la revendication 1, **caractérisé en ce que** la couche de conversion est constituée de pigments de conversion de couleur inorganiques ou organiques, lesquels sont distribués dans une couche de matière plastique organique (6).

3. Module LED qui présente un ensemble de LED blanchesselon l'une des revendications précédentes, où les puces de LED (2a, 2b, 2c, 2d) des LED bleues Face Down sont disposées sur un matériau support (1).

4. Module LED selon la revendication 3,
**caractérisé en ce**
**que** le matériau support (1) est un support semi-conducteur ou une plaque de circuit imprimé.
